# EUROPEAN PATENT APPLICATION

(11) **EP 4 546 395 A1**
(43) Date of publication of application: **30.04.2025**
(21) Application number: 23831196.3
(22) Date of filing: 20.06.2023
(51) Int. Cl.: H01L 21/304, B24B 37/00, C09G 1/02, C09K 3/14

(54) **POLISHING MATERIAL SLURRY AND POLISHING METHOD OF SAME**

(30) Priority: 27.06.2022 JP 2022102366
(71) Applicant: Mitsui Mining & Smelting Co., Ltd, Shinagawa-ku Tokyo 141-8584 (JP)
(72) Inventor: NAKAMURA, Takuma, Omuta-shi, Fukuoka 836-0003 (JP); SARUWATARI, Yasunobu, Omuta-shi, Fukuoka 836-0003 (JP)
(74) Representative: Novagraaf Technologies
(86) International application number: PCT/JP2023/022707
(87) International publication number: WO 2024/004750

(57) **Abstract**

An abrasive slurry of the present invention includes manganese oxide abrasive grains containing manganese oxide particles, permanganate ions, and phosphates. Furthermore, in a polishing method of the abrasive slurry of the present invention, an object to be polished is polished using the abrasive slurry of the present invention.

## Description

### Technical Field

The present invention relates to an abrasive slurry and a polishing method of the same.

### Background Art

Among semiconductor devices, a power semiconductor device, a so-called power device, requires an increase in withstand voltage and an increase in current, which are achieved by using silicon carbide (SiC), gallium nitride, diamond, or the like instead of silicon that has been conventionally used as a substrate. Since the substrates formed of these materials have a larger band gap than a conventional silicon substrate, the substrates can withstand a higher voltage.

Among them, a substrate formed of silicon carbide (hereinafter, the substrate is referred to as a SiC substrate) is not only excellent in hardness, heat resistance, and scientific stability, but also excellent in terms of cost. On the other hand, since a SiC substrate has higher hardness than that of a conventional silicon substrate, an abrasive slurry containing manganese oxide particles as abrasive grains disclosed in, for example, Patent Literature 1 has been developed as an abrasive slurry used in a step of finishing the surface of the SiC substrate to a mirror surface, which is a polishing step performed by a so-called chemical mechanical polishing (CMP) method or the like, among the SiC substrate production steps.

### Citation List

### Patent Literature

Patent Literature 1: JP 2017-071787 A

### Summary of Invention

### Technical Problem

However, since the abrasive slurry containing manganese oxide particles as abrasive grains as disclosed in Patent Literature 1 often has insufficient dispersibility, and the abrasive slurry is in a thick liquid state, there is a problem that the supply tube for supplying the abrasive slurry is easily clogged. In addition, during the polishing treatment, the abrasive slurry adheres to the surface of the SiC substrate which is an object to be polished or a device such as a polishing pad used for polishing, causing the abrasive slurry to be hardly removed even when the polishing pad or the SiC substrate is cleaned after the polishing treatment, and the cleaning treatment to be time-consuming.

In view of the above problems, an object of the present invention is to provide an abrasive slurry which is excellent in dispersibility and exhibits a high polishing rate and a polishing method.

### Solution to Problem

The abrasive slurry of the present invention that has been developed to solve the above problems includes manganese oxide abrasive grains containing manganese oxide particles, permanganate ions, and phosphates.

Since the abrasive slurry of the present invention includes the manganese oxide abrasive grains containing the manganese oxide particles, the permanganate ions, and the phosphates, the abrasive slurry has excellent dispersibility and exhibits a high polishing rate.

Examples of the manganese oxide particles contained in the manganese oxide abrasive grains include manganese (II) oxide (MnO), dimanganese (III) trioxide (Mn₂O₃), manganese (IV) dioxide (MnO₂), and trimanganese (II, III) tetraoxide (Mn₃O₄). The manganese oxide abrasive grains may be one kind or a mixture of two or more kinds of the manganese oxide particles.

In addition, the manganese oxide abrasive grains may contain abrasive grains other than the manganese oxide particles described above as long as the effect of preventing warpage and cracking due to the Twyman effect exerted on, for example, the SiC substrate, which is an object to be polished by the abrasive slurry of the present invention, is not impaired. Examples of the abrasive grains other than the manganese oxide particles include a compound such as an oxide, a hydroxide, or a carbide of at least one element selected from Mg, B, Si, Ce, Al, Zr, Fe, Ti, and Cr, and other carbon materials. Specific examples of the abrasive grains other than the manganese oxide particles include alumina, silica, cerium oxide, zirconium oxide, titanium oxide, chromium oxide, iron oxide, magnesium hydroxide, cerium hydroxide, silicon carbide, boron carbide, and diamond. These may be used singly or in combination of two or more kinds thereof. In addition, the manganese oxide particles may be combined with the abrasive grains other than the manganese oxide particles. For example, the surfaces of the manganese oxide particles may be coated with the abrasive grains other than the manganese oxide particles, or the surfaces of the abrasive grains other than the manganese oxide particles may be coated with the manganese oxide particles.

In addition, the particle size of the manganese oxide abrasive grains at a cumulative volume of 50% (D50), which is measured by a laser diffraction/scattering particle size distribution measurement method, is preferably 0.1 µm or more from the viewpoint of having a high polishing force, and is preferably 5.0 µm or less from the viewpoint of preventing roughness of the surface of the object to be polished, for example, a SiC substrate. Therefore, the particle size of the manganese oxide abrasive grains at a cumulative volume of 50% (D50), which is measured by a laser diffraction/scattering particle size distribution measurement method, is more preferably 0.15 µm or more and 4.5 µm or less and even more preferably 0.2 µm or more and 4.0 µm or less.

Here, for the particle size of the manganese oxide abrasive grains at a cumulative volume of 50% (D50), which is measured by a laser diffraction/scattering particle size distribution measurement method, a measurement sample is prepared in a production method for the abrasive slurry of the present invention described later by obtaining a mixture by pulverizing the manganese oxide abrasive grains using beads and diluting the mixture with water so that the concentration of the mixture becomes about 0.01%. Then, measurement is performed using a laser diffraction/scattering method particle size distribution measuring apparatus (MT3300EXII manufactured by MicrotracBEL Corp.).

Furthermore, the content of the manganese oxide abrasive grains contained in the abrasive slurry of the present invention is preferably 0.5 mass% or more and 20 mass% or less and more preferably 0.5 mass% or more and 10 mass% or less with respect to the total amount of the polishing slurry from the viewpoint of sufficiently increasing the polishing rate of a high hardness material such as silicon carbide, the viewpoint of securing suitable fluidity of the abrasive grains in the polishing slurry, the viewpoint of preventing aggregation, and the like. In addition, the content of the manganese oxide particles contained in the manganese oxide abrasive grains is more preferably 1 mass% or more and 5 mass% or less from the viewpoint of sufficiently increasing the polishing rate. In the present specification, the content in the abrasive slurry of the present invention is the content in the polishing slurry before the start of polishing unless otherwise specified.

The abrasive slurry of the present invention also includes permanganate ions (MnO₄⁻) in addition to the manganese oxide abrasive grains described above. The permanganate ions act as an oxidizing agent, and when used in combination with the manganese oxide abrasive grains, the permanganate ion can have a high polishing force with respect to a high hardness material such as silicon carbide. Here, the supply source of the permanganate ions is preferably permanganate. Examples of the permanganate include an alkali metal salt of permanganic acid and an alkaline earth metal salt of permanganic acid. Furthermore, from the viewpoint of easy availability and the viewpoint of improving the polishing efficiency of the abrasive slurry of the present invention, among the permanganates as a supply source of the permanganate ions, an alkali metal salt of permanganic acid is preferable, and sodium permanganate or potassium permanganate is more preferable. These permanganates may be used singly or in combination of two or more kinds thereof.

In addition, the content of the permanganate ions in the abrasive slurry of the present invention is preferably 0.5 mass% or more with respect to the total amount of the abrasive slurry of the present invention from the viewpoint of sufficiently increasing the polishing rate. In addition, the content of the permanganate ions in the abrasive slurry of the present invention is preferably 3.2 mass% or less with respect to the total amount of the abrasive slurry of the present invention from the viewpoint of preventing crystal precipitation due to an increase in the addition amount, the viewpoint of ensuring the safety in handling of the abrasive slurry, the viewpoint that the polishing rate tends to be saturated even when the addition amount is increased, and the like. That is, the content of the permanganate ions is preferably 0.5 mass% or more and 3.2 mass% or less and more preferably 1.0 mass% or more and 2.1 mass% or less with respect to the total amount of the abrasive slurry of the present invention. The content of the permanganate ions is measured by ion chromatography or absorptiometry.

The abrasive slurry of the present invention further includes phosphates in addition to the manganese oxide abrasive grains and the permanganate ions described above. When phosphates are used in combination with the manganese oxide abrasive grains and the permanganate ions, dispersibility of the abrasive slurry of the present invention can be improved.

The phosphates contained in the abrasive slurry of the present invention are preferably, for example, inorganic phosphorus compounds. Specific examples of the inorganic phosphorus compounds include phosphate compounds such as a sodium phosphate (trisodium phosphate (anhydrous) (Na₃PO₄), CAS number: 7601-54-9; trisodium phosphate-dodecahydrate (Na₃PO₄·12H₂O), CAS number: 10101-89-0; monobasic sodium phosphate (NaH₂PO₄), CAS number: 7558-80-7; and dibasic sodium phosphate (Na₂HPO₄), CAS number: 7558-79-4) and a potassium phosphate (tripotassium phosphate (anhydrous) (K₃PO₄), CAS number: 7778-53-2; tripotassium phosphate-monohydrate (K₃PO₄·H₂O), CAS number: 27176-10-9; dibasic potassium phosphate·trihydrate (K₂HPO₄·H₂O), CAS number: 16788-57-1; monobasic potassium phosphate (KH₂PO₄), CAS number: 7778-77-0; and dipotassium phosphate (K₂HPO₄), CAS number: 7758-11-4).

Moreover, examples of a metaphosphate compound include sodium metaphosphate (NaPO₃)ₙ, CAS number: 35270-09-8) and potassium metaphosphate (KPO₃)ₙ, CAS number: 7790-53-6.

Examples of a hexametaphosphate compound include sodium hexametaphosphate (NaH₇P₆O₁₈), CAS number: 10124-56-8.

Examples of a pyrophosphate compound include a sodium pyrophosphate (sodium pyrophosphate (anhydrous) (Na₄P₂O₇), CAS number: 7722-88-5; sodium pyrophosphate·decahydrate (Na₄P₂O₇·10H₂O), CAS number: 13472-36-1; and sodium acid pyrophosphate (Na₂H₂P₂O₇) , CAS number: 7758-16-9), and potassium pyrophosphate (K₄P₂O₇), CAS number: 7320-34-5.

Examples of a polyphosphate compound include sodium polyphosphate (Na₃P₃O₁₀X₂), CAS number: 68915-31-1; and potassium polyphosphate (K₃P₃O₁₀X₂), CAS number: 68956-75-2.

Examples of a tripolyphosphate compound include sodium tripolyphosphate (Na₅P₃O₁₀), CAS number: 7758-29-4 and potassium tripolyphosphate (K₅P₃O₁₀), CAS number: 13845-36-8.

The examples also include salts and hydrates of these compounds. In the case of the salts of these compounds, alkali metal salts and alkaline earth metal salts are preferable, and particularly sodium salts and potassium salts are more preferable. In particular, in the abrasive slurry of the present invention, from the viewpoint of effective high dispersibility in a small amount and the viewpoint of sufficiently increasing the polishing rate, a metaphosphate compound, a hexametaphosphate compound, a pyrophosphate compound (sodium pyrophosphate or potassium pyrophosphate), a polyphosphate compound (sodium polyphosphate or potassium polyphosphate), and a tripolyphosphate compound are more preferable. These phosphates may be used singly or in combination of two or more kinds thereof.

Furthermore, among the inorganic phosphorus compounds described above, a pyrophosphate compound is preferable from the viewpoint of high dispersibility and the viewpoint of sufficiently increasing the polishing rate. The pyrophosphate compound is more preferably an alkali metal salt of pyrophosphoric acid or an alkaline earth metal salt of pyrophosphoric acid, and particularly preferably sodium pyrophosphate or potassium pyrophosphate.

In addition, the content of the phosphates in the abrasive slurry of the present invention is preferably 0.01 mass% or more with respect to the total amount of the abrasive slurry of the present invention from the viewpoint of dispersibility. In addition, the content of the phosphates in the abrasive slurry of the present invention is preferably 0.1 mass% or less with respect to the total amount of the abrasive slurry of the present invention from the viewpoint that the polishing rate tends to be saturated even when the addition amount is increased. That is, the content of the phosphates is preferably 0.01 mass% or more and 0.1 mass% or less with respect to the total amount of the abrasive slurry of the present invention, more preferably 0.02 mass% or more from the viewpoint of improving the dispersibility, and more preferably 0.05 mass% or less from the viewpoint of sufficiently increasing the polishing rate. In the present specification, the content of the phosphates is the total amount of those classified as phosphates unless otherwise specified.

Furthermore, the content of the phosphates in the abrasive slurry of the present invention is preferably 0.5% or more and 5.0% or less when expressed as a mass ratio with respect to the content of the manganese oxide abrasive grains in the abrasive slurry of the present invention. It is more preferably 0.8% or more and 3.0% or less, and still more preferably 1.0% or more and 2.0% or less.

In addition, the abrasive slurry of the present invention further includes a cellulose-based surfactant and/or a cationic surfactant.

When the abrasive slurry of the present invention further includes the cellulose-based surfactant and/or the cationic surfactant, the low frictional property can be improved.

As the cellulose-based surfactant, any of an anionic surfactant, a cationic surfactant, and a nonionic surfactant is known. First, examples of the anionic surfactant include those in which a negative group such as a carboxyl group, an alkoxyl group, or a hydroxyl group is introduced into the cellulose backbone. Examples of the cationic surfactant include cationized cellulose. Examples of the nonionic group include alkyl celluloses such as ethyl cellulose, hydroxyethyl cellulose, hydroxypropyl cellulose, hydroxyethyl methyl cellulose, and hydroxypropyl methyl cellulose.

Among these cellulose-based surfactants, anionic surfactants are preferable, in particular, those containing a carboxyl group are more preferable, and carboxymethyl cellulose and derivatives thereof are preferable from the viewpoint of a low frictional property. Carboxymethyl cellulose is a compound in which a carboxymethyl group is bonded to some of the hydroxyl groups of a glucopyranose monomer constituting the cellulose backbone. Examples of the carboxymethyl cellulose derivative include alkali metal salts of carboxymethyl cellulose, specifically, salts such as sodium and potassium salts. Furthermore, examples of the carboxymethyl cellulose derivative include those in which a hydroxyl group, an alkyl group, or the like is bonded to a side chain thereof as long as the surfactant action of carboxymethyl cellulose is not lost. In addition, examples of the cellulose-based surfactant include crystalline cellulose and modified products thereof (for example, AVICEL manufactured by Asahi Kasei Corp.). These cellulose-based surfactants may be used singly or in combination of two or more kinds thereof.

Examples of the cationic surfactant include an amine salt type surfactant and a quaternary ammonium salt type surfactant, and it is preferable that the cationic surfactant has a quaternary ammonium ion moiety. Here, examples of the cationic surfactant having a quaternary ammonium ion moiety include a salt represented by the following General Formula (1). 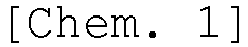 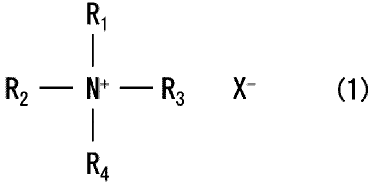 (In General Formula (1), R₁, R₂, R₃, and R₄ are each independently an alkyl group, an aryl group, or an arylalkyl group, or R₁, R₂, and R₃ are bonded to form a pyridine ring, and R₄ is an alkyl group, an aryl group, or an arylalkyl group, and X⁻ is a monovalent anion.)

In General Formula (1), the alkyl group represented by R₁, R₂, R₃, and R₄ is preferably an alkyl group having 1 to 20 carbon atoms, and specific examples thereof include a methyl group, an ethyl group, a propyl group, an isopropyl group, a n-butyl group, a s-butyl group, a t-butyl group, an isobutyl group, an amyl group, an isoamyl group, a t-amyl group, a hexyl group, a heptyl group, an isoheptyl group, a t-heptyl group, a n-octyl group, an isooctyl group, a 2-ethylhexyl group, a t-octyl group, a nonyl group, an isononyl group, a decyl group, an isodecyl group, an undecyl group, a dodecyl group, a tridecyl group, an isotridecyl group, a tetradecyl group, a hexadecyl group, an octadecyl group, and an icosyl group, and a linear alkyl group is preferable. The aryl group represented by R₁, R₂, R₃, and R₄ is preferably a phenyl group. The arylalkyl group represented by R₁, R₂, R₃, and R₄ is preferably a benzyl group, a phenethyl group, or the like. The monovalent anion represented by X⁻ is preferably a halide ion. The halide ion is preferably a chloride ion or a bromide ion. The aromatic ring in the aryl group or arylalkyl group represented by R₁, R₂, R₃, and R₄ and the pyridine ring formed by the bonding of R₁, R₂, and R₃ may be substituted with an alkyl group or an amino group, and the methylene group in the arylalkyl group may be substituted with -O-. The pyridine ring formed by the bonding of R₁, R₂, and R₃ may be fused with a benzene ring.

Examples of the cationic surfactant represented by General Formula (1) include distearyl dimethyl ammonium chloride (rational formula C₁₈H₃₇N⁺C₁₈H₃₇(CH₃)₂·Cl⁻) , benzalkonium chloride (rational formula C₆H₅CH₂N⁺(CH₃)₂R Cl⁻ (R = C₈H₁₇ to C₁₈H₃₇, long-chain alkyl)), benzethonium chloride (molecular formula C₂₇H₄₂ClNO₂), cetylpyridinium chloride (molecular formula C₂₁H₃₈NCl), hexadecyltrimethylammonium bromide (rational formula (C₁₆H₃₃)N⁺(CH₃)₃Br⁻), and dequalinium chloride (molecular formula C₃₀H₄₀Cₗ₂N₄).

In addition, the total content of the cellulose-based surfactant and/or the cationic surfactant in the abrasive slurry of the present invention is preferably 0.1 mass% or more with respect to the total amount of the abrasive slurry of the present invention from the viewpoint of improving the low frictional property. In addition, the total content of the cellulose-based surfactant and/or the cationic surfactant in the abrasive slurry of the present invention is preferably 1 mass% or less with respect to the total amount of the abrasive slurry of the present invention from the viewpoint of sufficiently increasing the polishing rate. That is, the total content of the cellulose-based surfactant and/or the cationic surfactant is preferably 0.1 mass% or more and 1 mass% or less and more preferably 0.1 mass% or more and 0.5 mass% or less with respect to the total amount of the abrasive slurry of the present invention. In the present specification, the total content of the cellulose-based surfactant and/or the cationic surfactant is the content of the cellulose-based surfactant or the cationic surfactant when the abrasive slurry contains only one of the cellulose-based surfactant and/or the cationic surfactant, and the total amount of both of the cellulose-based surfactant and the cationic surfactant when the abrasive slurry contains both of the surfactants, unless otherwise specified.

In the abrasive slurry of the present invention, the content of the manganese oxide abrasive grains is 0.5 mass% or more and 20 mass% or less, the content of the permanganate ions is 0.5 mass% or more and 3.2 mass% or less, and the content of the phosphates is 0.01 mass% or more and 0.1 mass% or less.

It is preferable that, in the abrasive slurry of the present invention, the content of the manganese oxide abrasive grains is 0.5 mass% or more and 20 mass% or less, the content of the permanganate ions is 0.5 mass% or more and 3.2 mass% or less, and the content of the phosphates is 0.01 mass% or more and 0.1 mass% or less as described above, from the viewpoint of having excellent dispersibility and exhibiting a high polishing rate.

In addition, in the abrasive slurry of the present invention, the content of the manganese oxide abrasive grains is 0.5 mass% or more and 20 mass% or less, the content of the permanganate ions is 0.5 mass% or more and 3.2 mass% or less, the content of the phosphates is 0.01 mass% or more and 0.1 mass% or less, and the total content of the cellulose-based surfactant and/or the cationic surfactant is 1.0 mass% or less.

It is preferable that, in the abrasive slurry of the present invention, the content of the manganese oxide abrasive grains is 0.5 mass% or more and 20 mass% or less, the content of the permanganate ions is 0.5 mass% or more and 3.2 mass% or less, the content of the phosphates is 0.01 mass% or more and 0.1 mass% or less, and the total content of the cellulose-based surfactant and/or the cationic surfactant is 1.0 mass% or less as described above, from the viewpoint of having an excellent low frictional property in addition to having excellent dispersibility and exhibiting a high polishing rate.

Here, the abrasive slurry of the present invention includes a dispersion medium for dissolving or dispersing the manganese oxide abrasive grains, the permanganate ions, the phosphates, and the cellulose-based surfactant and/or the cationic surfactant described above. The dispersion medium is preferably water or a water-soluble organic solvent such as an alcohol or a ketone, or a mixture thereof from the viewpoint of sufficiently increasing the polishing rate, and more preferably water. The content of the dispersion medium is preferably 60 mass% or more and 99.9 mass% or less and more preferably 80 mass% or more and 90 mass% or less with respect to the total amount of the abrasive slurry.

The abrasive slurry of the present invention may further include a certain additive other than the manganese oxide abrasive grains, the permanganate ions, the phosphates, the cellulose-based surfactant and/or the cationic surfactant, and the dispersion medium described above. Here, the certain additive is a dispersant, a pH adjusting agent, a viscosity adjusting agent, a chelating agent, a rust inhibitor, or the like. The content of the certain additive is preferably 40 mass% or less, more preferably 20 mass% or less, and even more preferably 10 mass% or less with respect to the total amount of the abrasive slurry of the present invention.

The abrasive slurry of the present invention can include the above-described manganese oxide abrasive grains, permanganate ions, phosphates, cellulose-based surfactant and/or cationic surfactant, dispersion medium, and a certain additive in an appropriately mixed form. For example, the abrasive slurry may be prepared as a kit in which these components are divided into two or more agents. The kit may be configured in any manner as long as the polishing ability is sufficiently exhibited when the abrasive slurry is adjusted.

A polishing method for polishing an object to be polished using the above-described abrasive slurry of the present invention will be described below.

Examples of the polishing method include a polishing method in which the abrasive slurry of the present invention is supplied to a polishing pad, the surface to be polished on the object to be polished is brought into contact with the polishing pad, and polishing is performed by relative movement between the surface to be polished and the polishing pad. Here, a method of pouring the abrasive slurry of the present invention, or a method of circulating the abrasive slurry of the present invention in which an operation of collecting the abrasive slurry of the present invention supplied to the polishing pad and used for the polishing and supplying the collected abrasive slurry of the present invention to the polishing pad again is repeated may be performed. Since the abrasive slurry of the present invention can circulate and repeatedly polish the object to be polished, the amount of the abrasive slurry used can be reduced. Here, as the polishing pad, for example, a conventionally used nonwoven fabric, a pad obtained by impregnating the nonwoven fabric with a resin such as polyurethane or epoxy, a suede material, or the like can be used. The polishing pressure is preferably 0.5 × 10⁴ Pa or more and 1.0 × 10⁵ Pa or less, particularly 1.0 × 10⁴ Pa or more and 5.0 × 10⁴ Pa or less from the viewpoint of a polishing force, ease of handling a polishing jig, and the like. The supply amount of the abrasive slurry is preferably 10 mL/min or more and 500 mL/min or less, and more preferably 50 mL/min or more and 250 mL/min or less.

The object to be polished which is polished by the abrasive slurry of the present invention is, for example, a high hardness material having a Mohs hardness of 8 or more. Here, the Mohs hardness is obtained by quantifying the hardness based on how a material is scratched by a reference material, and can be measured by a conventional method using a Mohs Scale of Hardness. As the Mohs hardness, reference materials from 1 to 10 are specified in order from a softer material, and the specific reference materials are as follows: Mohs hardness 1 is talc, 2 is gypsum, 3 is calcite, 4 is fluorite, 5 is apatite, 6 is orthoclase, 7 is quartz, 8 is topaz, 9 is corundum, and 10 is diamond. Examples of the high hardness material having a Mohs hardness of 8 or more include silicon carbide (Mohs hardness of about 9), gallium nitride (Mohs hardness of about 9), and diamond.

The abrasive slurry of the present invention can be used in a finishing chemical mechanical polishing (CMP) process or the like after wrapping of a substrate formed of a high hardness material. In particular, the abrasive slurry of the present invention can be used for polishing a substrate formed of silicon carbide (SiC), that is, a SiC substrate, and can sufficiently increase the polishing rate and effectively prevent the occurrence of warpage and cracking due to the Twyman effect. As the SiC substrate, a monocrystalline silicon carbide substrate is usually used, and examples of the crystal system thereof usually include hexagonal crystals and rhombohedral crystals. From the viewpoint of exerting the effect of the abrasive slurry which is the ability to prevent the occurrence of warpage and cracking due to the Twyman effect, hexagonal crystals are preferable. Examples of the hexagonal polymorph include 2H, 4H, 6H, 8H, and 10H. Examples of the rhombohedral polymorph include 15R.

Next, a method for producing the above-described abrasive slurry of the present invention will be described below.

First, pure water, manganese dioxide (abrasive grains, MnO₂), phosphates (for example, sodium salt of pyrophosphoric acid), and beads (zirconia, φ 0.4 mm) are placed in a container, the container is set on a paint shaker (60 Hz), and the container is rotated at a high speed, thus mixing and pulverizing the manganese dioxide (abrasive grains, MnO₂).

Using a centrifuge (himac CT 6E manufactured by Hitachi Koki Co., Ltd.) or the like, the beads are separated from the mixture in the container containing the manganese dioxide (abrasive grains, MnO₂) which has been mixed and pulverized, and the supernatant is collected.

The solid content concentration, that is, the concentration of the manganese oxide abrasive grains in the collected supernatant is measured with a heating type aquameter, and pure water is added to a predetermined concentration to obtain an abrasive slurry intermediate. The cellulose-based surfactant and/or the cationic surfactant may be added to the obtained abrasive slurry intermediate.

Then, the abrasive slurry intermediate and potassium permanganate (KMnO₄) are mixed to obtain the abrasive slurry of the present invention.

Note that, in the present specification, the expression "X to Y" (X and Y are any numbers) encompasses the meaning of "preferably larger than X" or "preferably smaller than Y" as well as the meaning of "X or more and Y or less", unless otherwise specified. In addition, the expression "X or more" (X is any number) or "Y or less" (Y is any number) encompasses the intention of "preferably greater than X" or "preferably less than Y".

### Advantageous Effects of Invention

The abrasive slurry of the present invention is excellent in dispersibility and capable of sufficiently increasing the polishing rate.

### Brief Description of Drawings

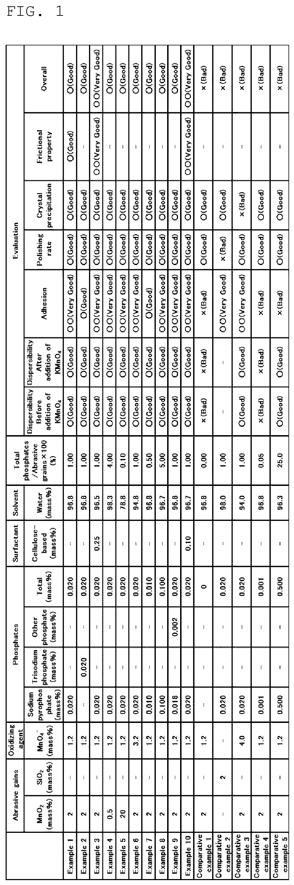

Fig. 1 is a list of physical property values and measurement results of abrasive slurries according to Examples 1 to 10 and Comparative Examples 1 to 5.

### Best Mode for Carrying Out the Invention

Hereinafter, the abrasive slurry of an embodiment according to the present invention will be further described based on the following Examples. However, the following Examples do not limit the present invention.

### (Example 1)

Pure water, manganese dioxide (MnO₂) as abrasive grains, a sodium pyrophosphate (specifically, sodium pyrophosphate·decahydrate (Na₄P₂O₇·10H₂O), CAS number: 13472-36-1) as phosphates, and beads (zirconia, φ 0.4 mm) were placed in a container, the container was set on a paint shaker (60 Hz), and the container was rotated at a high speed, thus mixing and pulverizing the manganese dioxide. The contents of these components were prepared so that the content of the manganese dioxide was 30 mass%, and the content of the sodium pyrophosphate was 0.3 mass% with respect to the total amount of an abrasive slurry according to Example 1.

Using a centrifuge ((himac CT 6E manufactured by Hitachi Koki Co., Ltd.) or the like, the beads were separated from the mixture in the container containing the manganese dioxide which had been mixed and pulverized, and the supernatant was collected. The supernatant obtained in this step serves as a measurement sample before addition of potassium permanganate in the dispersibility test described later.

The solid content concentration, that is, the concentration of the manganese oxide abrasive grains in the collected supernatant was measured with a heating type aquameter, and pure water was added to a predetermined concentration to obtain an abrasive slurry intermediate.

Then, the abrasive slurry intermediate and an aqueous potassium permanganate (KMnO₄) solution having a KMnO₄ mass% concentration of 3.2 mass% were mixed to obtain the abrasive slurry according to Example 1. The content of permanganate ions was prepared to be 1.2 mass% with respect to the total amount of the abrasive slurry according to Example 1. In addition, the mass ratio of the total content of the phosphates to the content of the manganese oxide abrasive grains according to Example 1 was 1.0%. Note that the abrasive slurry according to Example 1 obtained in this step serves as a measurement sample after addition of potassium permanganate in the dispersibility test described later. In addition, the composition of the abrasive slurry shown in Fig. 1 is the composition in the final product.

### (Example 2)

In Example 2, an abrasive slurry according to Example 2 was obtained by performing the same production method as in Example 1, except that trisodium phosphate was prepared so that the content thereof was 0.3 mass% with respect to the total amount of the abrasive slurry according to Example 2, instead of the sodium pyrophosphate used in Example 1. The mass ratio of the total content of the phosphates to the content of the manganese oxide abrasive grains according to Example 2 was 1.0%.

### (Example 3)

In Example 3, an abrasive slurry according to Example 3 was obtained by performing the same production method as in Example 1, except that, before the abrasive slurry intermediate of Example 1 and potassium permanganate (KMnO₄) were mixed, carboxymethyl cellulose was added to and mixed with the abrasive slurry intermediate of Example 1 in addition to the components used in Example 1 as a cellulose-based surfactant prepared so that the content thereof was 0.25 mass% with respect to the total amount of the abrasive slurry according to Example 3. The mass ratio of the total content of the phosphates to the content of the manganese oxide abrasive grains according to Example 3 was 1.0%.

### (Example 4)

In Example 4, an abrasive slurry according to Example 4 was obtained by performing the same production method as in Example 1, except that the content of manganese dioxide (MnO₂) serving as the abrasive grains was prepared to be 0.5 mass% with respect to the total amount of the abrasive slurry according to Example 4. The mass ratio of the total content of the phosphates to the content of the manganese oxide abrasive grains according to Example 4 was 4.0%.

### (Example 5)

In Example 5, an abrasive slurry according to Example 5 was obtained by performing the same production method as in Example 1, except that the content of manganese dioxide (MnO₂) serving as the abrasive grains was prepared to be 20 mass% with respect to the total amount of the abrasive slurry according to Example 5. The mass ratio of the total content of the phosphates to the content of the manganese oxide abrasive grains according to Example 5 was 0.1%.

### (Example 6)

In Example 6, an abrasive slurry according to Example 6 was obtained by performing the same production method as in Example 1, except that the abrasive slurry intermediate was mixed with an aqueous potassium permanganate (KMnO₄) solution having a KMnO₄ mass% concentration of 5.6 mass%, and the content of the permanganate ions was prepared to be 3.2 mass% with respect to the total amount of the abrasive slurry according to Example 6. The mass ratio of the total content of the phosphates to the content of the manganese oxide abrasive grains according to Example 6 was 1.0%.

### (Example 7)

In Example 7, an abrasive slurry according to Example 7 was obtained by performing the same production method as in Example 1, except that the content of the sodium pyrophosphate was prepared to be 0.01 mass% with respect to the total amount of the abrasive slurry according to Example 7. The mass ratio of the total content of the phosphates to the content of the manganese oxide abrasive grains according to Example 7 was 0.5%.

### (Example 8)

In Example 8, an abrasive slurry according to Example 8 was obtained by performing the same production method as in Example 1, except that the content of the sodium pyrophosphate was prepared to be 0.1 mass% with respect to the total amount of the abrasive slurry according to Example 8. The mass ratio of the total content of the phosphates to the content of the manganese oxide abrasive grains according to Example 8 was 5.0%.

### (Example 9)

In Example 9, an abrasive slurry according to Example 9 was obtained by performing the same production method as in Example 1, except that the content of the sodium pyrophosphate was prepared to be 0.018 mass% with respect to the total amount of the abrasive slurry according to Example 9, and other phosphates (specifically, a sample obtained by mixing each of tripotassium phosphate (anhydrous) (K₃PO₄), CAS number: 7778-53-2, sodium metaphosphate (NaPO₃)ₙ, CAS number: 35270-09-8, potassium pyrophosphate (K₄P₂O₇), CAS number: 7320-34-5, sodium polyphosphate (Na₃P₃O₁₀X₂), CAS number: 68915-31-1, and sodium tripolyphosphate (Na₅P₃O₁₀), CAS number: 7758-29-4 in equal amounts) were prepared so that the content thereof was 0.002 mass% (the total amount of the phosphates was 0.02 mass%). The mass ratio of the total content of the phosphates to the content of the manganese oxide abrasive grains according to Example 9 was 1.0%.

### (Example 10)

In Example 10, an abrasive slurry according to Example 10 was obtained by performing the same production method as in Example 1, except that, before the abrasive slurry intermediate of Example 1 and potassium permanganate (KMnO₄) were mixed, carboxymethyl cellulose was added to and mixed with the abrasive slurry intermediate of Example 1 as a cellulose-based surfactant prepared so that the content thereof was 0.1 mass% with respect to the total amount of the abrasive slurry according to Example 10. The mass ratio of the total content of the phosphates to the content of the manganese oxide abrasive grains according to Example 10 was 1.0%.

### (Comparative Example 1)

In Comparative Example 1, an abrasive slurry according to Comparative Example 1 was obtained by performing the same manufacturing method as in Example 1, except that the phosphates were not added. The mass ratio of the total content of the phosphates to the content of the manganese oxide abrasive grains according to Comparative Example 1 was 0.0%.

### (Comparative Example 2)

In Comparative Example 2, an abrasive slurry according to Comparative Example 2 was obtained by performing the same production method as in Example 1, except that silicon dioxide (SiO₂) was prepared so that the content thereof was 2.0 mass% with respect to the total amount of the abrasive slurry according to Comparative Example 2 instead of manganese dioxide (MnO₂) used in Example 1, and potassium permanganate (KMnO₄) was not added to the abrasive slurry intermediate. The mass ratio of the total content of the phosphates to the content of the silicon oxide abrasive grains according to Comparative Example 2 was 1.0%.

### (Comparative Example 3)

In Comparative Example 3, an abrasive slurry according to Comparative Example 3 was obtained by performing the same production method as in Example 1, except that the abrasive slurry intermediate was mixed with an aqueous potassium permanganate (KMnO₄) solution having a KMnO₄ mass% concentration of 5.6 mass%, and the content of permanganate ions was prepared to be 4 mass% with respect to the total amount of the abrasive slurry according to Comparative Example 3. The mass ratio of the total content of the phosphates to the content of the manganese oxide abrasive grains according to Comparative Example 3 was 1.0%.

### (Comparative Example 4)

In Comparative Example 4, an abrasive slurry according to Comparative Example 4 was obtained by performing the same production method as in Example 1, except that the content of the sodium pyrophosphate was prepared to be 0.001 mass% with respect to the total amount of the abrasive slurry according to Comparative Example 4. The mass ratio of the total content of the phosphates to the content of the manganese oxide abrasive grains according to Comparative Example 4 was 0.05%.

### (Comparative Example 5)

In Comparative Example 5, an abrasive slurry according to Comparative Example 5 was obtained by performing the same production method as in Example 1, except that the content of the sodium pyrophosphate was prepared to be 0.5 mass% with respect to the total amount of the abrasive slurry according to Comparative Example 5. The mass ratio of the total content of the phosphates to the content of the manganese oxide abrasive grains according to Comparative Example 5 was 25%.

Then, the following physical property values were measured for the abrasive slurries according to Examples 1 to 10 and Comparative Examples 1 to 5. The physical property values that were measured and the method for measuring the physical property values are shown below, and the measurement results are shown in Fig. 1.

### <Evaluation of Particle Size>

Mixtures containing the abrasive grains in the abrasive slurries according to Examples 1 to 10 and Comparative Examples 1 to 5 which were mixed and pulverized by a paint shaker were diluted with water so that the concentrations of the mixtures were about 0.01%, thus preparing measurement samples. Then, the particle size (D50) at a volume-based cumulative fraction of 50% was measured using a laser diffraction/scattering method particle size distribution measuring apparatus (MT3300EXII manufactured by MicrotracBEL Corp.).

### <Evaluation of Dispersibility>

The dispersibility of the abrasive slurries according to Examples 1 to 10 and Comparative Examples 1 and 3 to 5 was evaluated before and after addition of potassium permanganate as a supply source of the permanganate ions, respectively.

First, the dispersibility before the addition of potassium permanganate was evaluated as follows. Mixtures containing the abrasive grains in the abrasive slurries according to Examples 1 to 10 and Comparative Examples 1 and 3 to 5 which were mixed and pulverized by a paint shaker were diluted with water so that the concentrations of the mixtures were about 0.01 mass%, thus preparing measurement samples. Then, the particle size (D50) at a volume-based cumulative fraction of 50% was measured using a laser diffraction/scattering method particle size distribution measuring apparatus (MT3300EXII manufactured by MicrotracBEL Corp.), and when D50 was 0.6 µm or less, it was evaluated as "○ (Good)", and when D50 was more than 0.6 µm, it was evaluated as "× (Bad)".

Next, the dispersibility after the addition of potassium permanganate was evaluated as follows. Measurement samples were prepared by diluting the abrasive slurries according to Examples 1 to 10 and Comparative Examples 1 and 3 to 5 with water so that the concentrations of the abrasive slurries were about 0.01 mass%. Then, the particle size (D50) at a volume-based cumulative fraction of 50% was measured using a laser diffraction/scattering method particle size distribution measuring apparatus (MT3300EXII manufactured by MicrotracBEL Corp.), and when D50 was 0.6 µm or less, it was evaluated as "○ (Good)", and when D50 was more than 0.6 µm, it was evaluated as "× (Bad)". Since potassium permanganate (KMnO₄) was not added to the abrasive slurry intermediate of the abrasive slurry according to Comparative Example 2, the evaluation of dispersibility described above was not performed.

### <Evaluation of Adhesion>

As for the adhesion of the abrasive slurries according to Examples 1 to 10 and Comparative Examples 1 to 5, when a container (250-ml wide-mouth bottle I-BOY manufactured by AS ONE CORPORATION) containing the sample used in the evaluation of dispersibility after the addition of potassium permanganate described above was inverted, the state of adhesion of each abrasive slurry to the container was visually confirmed by the examiner and judged as follows. When the container containing the sample was inverted, it was evaluated as "○○ (Very Good)" if the sample did not adhere to the container, it was evaluated as"○ (Good)" if the sample adhered only to the bottom of the container, and it was evaluated as "× (Bad)" if the sample adhered to the bottom and the side surface or the side surface of the container. For the abrasive slurry according to Comparative Example 2, the abrasive slurry intermediate to which potassium permanganate (KMnO₄) was not added was used as a sample.

### <Polishing Test>

The polishing rates of the abrasive slurries according to Example 1 to 10 and Comparative Example 1 to 5 were evaluated by the following procedure. As an object to be polished, a 4H-SiC substrate that has a diameter of 4 inches and an off angle of 4° and had been subjected to CMP processing was used. The polishing test was performed on the Si surface of the substrate. As a polishing apparatus, a single-side polishing machine BC-15 manufactured by MAT Co., LTD. was used. As a polishing pad attached to the surface plate, IC1000 manufactured by NITTA DuPont Incorporated was used. The rotation speed of the surface plate was set to 60 rpm, and the outer peripheral speed was set to 7,136 cm/min. The carrier rotation speed was set to 60 rpm, and the outer peripheral speed was set to 961 cm/min. Furthermore, the load at the time of polishing was 2.8 psi (about 1.96 × 10⁴ Pa). The supply amount of the abrasive slurry was set to 200 mL/min, polishing was performed for 1 hour, and the polishing rate was determined from the difference in the mass of the substrate which was the object to be polished before and after the polishing. When the polishing rate was 0.10 µm/h or more, it was evaluated as "○ (Good)", and when the polishing rate was less than 0.10 µm/h, it was evaluated as "× (Bad)".

### <Crystal Precipitation Test>

Each of samples of the abrasive slurries according to Examples 1 to 10 and Comparative Examples 1 to 5 was prepared. Each of the adjusted samples was stored in a refrigerator set at 10°C for 24 hours. Thereafter, each sample was taken out from the refrigerator, and the solid content concentration in each sample, that is, the total value of the concentration of the manganese oxide abrasive grains and the concentration of potassium permanganate was determined using a heating type aquameter. When the solid content concentration after the storage was 90% or more of the rate of retaining the solid content concentration before the storage, it was evaluated as "○○ (Good)", and when the solid content concentration after the storage was less than 90% of the rate of retaining the solid content concentration before the storage, it was evaluated as "× (Bad)".

### <Evaluation of Frictional Property>

The frictional properties of the abrasive slurries according to Examples 1, 3, and 10 were evaluated as follows. A polishing pad (IC1000 manufactured by NITTA DuPont Incorporated) was attached to and fixed on a surface plate of a polishing machine, the supply amount of 1 L of each of the abrasive slurries according to Examples 1, 3, and 102 was set to 200 mL/min, and the abrasive slurry was supplied onto the polishing pad in a circulating manner. In addition, a workpiece was placed on the polishing pad as an object to be polished. Furthermore, the surface plate of the polishing machine was rotated in a state where a spring balance was hooked to the workpiece, and the workpiece was rotated in the same direction as the surface plate by the forcible driving unit. Here, the forcible driving unit is provided with a rotating roller capable of abutting on the workpiece, and rotates the workpiece by rotating the rotating roller. Then, the spring balance was pulled in a direction in which the workpiece was separated from the forcible driving unit, and the forcible driving unit separated the rotating roller from the workpiece, so that the rotation of the workpiece was stopped. A digital display value (that is, tensile force) displayed only on the spring balance 30 seconds after the rotation of the workpiece stopped was measured. The tensile force thus measured was divided by the load of the workpiece to determine the friction coefficients of the abrasive slurries according to Examples 1, 3, and 10. When the friction coefficient was 0.35 or less, it was evaluated as "○ (Very Good)", when the friction coefficient was more than 0.35 and 0.38 or less, it was evaluated as "○ (Good)", and when the friction coefficient was more than 0.38, it was evaluated as "× (Bad)".

As shown in Fig. 1, the abrasive slurries according to Examples 1 to 10 were excellent in dispersibility since the particle sizes (D50) at a volume-based cumulative fraction of 50% in the particle size distribution obtained by the laser diffraction/scattering method before and after the addition of potassium permanganate which was the supply source of the permanganate ions were all 0.6 µm or less.

As for the abrasive slurries according to Examples 1, 3 to 6, and 8 to 10, the state of adhesion of the abrasive slurry to the container containing the sample when the container was inverted was confirmed, and as a result, the sample did not adhere to the container, and the adhesion was very good. In addition, as for the abrasive slurries according to Examples 2 and 7, the sample adhered only to the bottom of the container, and adhesion was good.

The polishing rates of the abrasive slurries according to Examples 1 to 10 were 0.10 µm/h or more, and thus, the abrasive slurries exhibited high polishing rates.

Since, in the abrasive slurries according to Examples 1 to 10, the solid content concentration after the storage for 24 hours in a refrigerator set at 10°C was 90% or more of the rate of retaining the solid content concentration before the storage, it was found that crystals did not precipitate.

Since the abrasive slurries according to Examples 1, 3, and 10 had friction coefficients of 0.38 or less, a low frictional property was realized.

The invention disclosed in the present specification includes, in addition to the configurations of each of the inventions and the embodiments, those specified by changing these partial configurations to other configurations disclosed in the present specification, those specified by adding other configurations disclosed in the present specification to these configurations, or those specified by deleting these partial configurations to the extent that a partial action and effect can be obtained and forming a superordinate concept, to the extent applicable.

### Industrial Applicability

The abrasive slurry according to the present invention is excellent in dispersibility and exhibits a high polishing rate, and is suitable as an abrasive for an object to be polished formed of a high hardness material. In addition, since the abrasive slurry according to the present invention is excellent in dispersibility, it leads to a reduction in environmental load from the viewpoint that a SiC substrate which is an object to be polished and a polishing pad are easily cleaned, and the amount of cleaning water used can be reduced, the viewpoint that the cleaning time can be shortened, and the viewpoint of that the amount of wastewater treated can be reduced. Furthermore, since the abrasive slurry according to the present invention exhibits a high polishing rate, the polishing treatment time can be shortened.

## Claims

1. An abrasive slurry comprising:
manganese oxide abrasive grains containing manganese oxide particles;
permanganate ions; and
phosphates.

2. The abrasive slurry according to claim 1,
wherein the phosphates are inorganic phosphorus compounds.

3. The abrasive slurry according to claim 2,
wherein the inorganic phosphorus compounds are pyrophosphate compounds.

4. The abrasive slurry according to claim 1, further comprising:
a cellulose-based surfactant and/or a cationic surfactant.

5. The abrasive slurry according to claim 4,
wherein the cellulose-based surfactant contains carboxymethyl cellulose.

6. The abrasive slurry according to any one of claims 1 to 3, wherein the content of the manganese oxide abrasive grains is 0.5 mass% or more and 20 mass% or less,
the content of the permanganate ions is 0.5 mass% or more and 3.2 mass% or less, and
the content of the phosphates is 0.01 mass% or more and 0.1 mass% or less.

7. The abrasive slurry according to claim 4 or 5, wherein the content of the manganese oxide abrasive grains is 0.5 mass% or more and 20 mass% or less,
the content of the permanganate ions is 0.5 mass% or more and 3.2 mass% or less,
the content of the phosphates is 0.01 mass% or more and 0.1 mass% or less, and
the total content of the cellulose-based surfactant and/or the cationic surfactant is 1.0 mass% or less.

8. A polishing method comprising:
polishing an object to be polished using the abrasive slurry according to any one of claims 1 to 5.

9. A polishing method comprising:
polishing an object to be polished using the abrasive slurry according to claim 6.

10. A polishing method comprising:
polishing an object to be polished using the abrasive slurry according to claim 7.
